# EUROPÄISCHE PATENTSCHRIFT

(11) **EP 0 760 021 B1**
(45) Veröffentlichungstag und Bekanntmachung des Hinweises auf die Patenterteilung: **04.03.1998**
(21) Anmeldenummer: 95915122.6
(22) Anmeldetag: 01.04.1995
(51) Int. Cl.: C23C 16/40, C23C 16/44, C23C 16/36, C23C 30/00, C23C 16/34, C23C 16/32

(54) **WERKZEUG, VERFAHREN ZUR HERSTELLUNG DES WERKZEUGES UND VERWENDUNG DES WERKZEUGES**
TOOL, PROCESS FOR PRODUCING THE TOOL AND USE OF THE TOOL
OUTIL, PROCEDE POUR LA FABRICATION DE CET OUTIL ET UTILISATION DE CET OUTIL

(30) Priorität: 20.05.1994 DE 4417729
(43) Veröffentlichungstag der Anmeldung: 05.03.1997
(73) Patentinhaber: Widia GmbH, 45145 Essen (DE)
(72) Erfinder: KÖNIG, Udo, D-45149 Essen (DE)
(74) Vertreter: Vomberg, Friedhelm, Dipl.-Phys.
(86) Internationale Anmeldenummer: DE9500449
(87) Internationale Veröffentlichungsnummer: WO9532317

(56) Entgegenhaltungen:
- WO-A-92/17623
- WO-A-94/12682
- DE-B- 3 027 688
- PATENT ABSTRACTS OF JAPAN vol. 017 no. 278 (C-1065) ,28.Mai 1993 & JP,A,05 009742 (NIPPON TELEGR & TELEPH CORP) 19.Januar 1993,
- 17TH INTERNATIONAL CONFERENCE ON METALLURGICAL COATINGS AND 8TH INTERNATIONAL THIN FILM CONFERENCE, SAN DIEGO, CA, USA, 2-6 APRIL 1990, ISSN 0040-6090, THIN SOLID FILMS, 1 DEC. 1990, SWITZERLAND, VUORINEN S ET AL 'Characterization of alpha -Al/sub 2/O/sub 3/, kappa -Al/sub 2/O/sub 3/, and alpha - kappa multioxide coatings on cemented carbides'
- PATENT ABSTRACTS OF JAPAN vol. 006 no. 235 (C-136) ,20.November 1982 & JP,A,57 137460 (SUMITOMO DENKI KOGYO KK) 25.August 1982,

## Beschreibung

Die Erfindung betrifft ein Werkzeug aus einem Grundkörper aus Hartmetall oder Cermet und einer auf dem Grundkörper aufgebrachten, aus Carbiden, Nitriden und/oder Carbonitriden des Titans und/oder des Zirkoniums und/oder Aluminiumoxid bestehenden mehrlagigen mittels eines CVD-Verfahrens aufgetragenen Oberflächenbeschichtung.

Die Erfindung betrifft ferner ein Verfahren zur Herstellung dieser Werkzeuge sowie die Verwendung dieser Werkzeuge.

In der Patentanmeldung WO-A-94/12682, Stand der Technik gemäß Art.54(3) EPÜ und korrespondierend zu DE-A-42 39 234, wird ein Werkzeug der eingangs genannten Art beschrieben, bei dem die Oberflächenbeschichtung aus mehreren in abwechselnder Folge durch ein thermisches CVD-Verfahren und durch ein durch Glimmentladung aktiviertes CVD-Verfahren (PCVD) aufgetragenen Lagen besteht. Die Gesamtdicke der Beschichtung beträgt 2 bis 40 µm, wobei jede einzelne Lage dicker als 0,2 µm ist.

Aus der Patentanmeldung WO-A-92/17623 ist ein Verfahren zur Abscheidung von α-Al₂O₃-Schichten mittels eines Puls-Plasma-CVD-Verfahrens bekannt, bei dem die Plasmaaktivierung an dem als Kathode geschalteten Grundkörper mit einer gepulsten Gleichspannung herbeigeführt wird.

Die einzelnen Schichten werden durch technisch verschiedene Verfahren aufgebracht. Beim (thermischen) CVD-Verfahren muß man zur Erzielung ausreichend hoher Beschichtungsraten Temperaturen von über 900°C und Drücke von über 10000 Pa anwenden. So wird in einem Ausführungsbeispiel der genannten Patentanmeldung ein Gasgemisch von 2,5% TiCl₄, 35% N₂ und 62,5% H₂ bei einer Temperatur von 940°C und einem Druck von 25000 Pa über die zu beschichtenden Substrate geleitet. Hiernach bzw. alternierend hierzu wurden Einzelschichten durch das PCVD-Verfahren aufgetragen, wobei beispielsweise ein Gasgemisch von 1,5% TiCl₄, 11,5% N₂, 8% Ar und 79% H₂ bei einem Druck von 300 Pa und einer Temperatur von 780°C angewendet worden ist. Die mehrlagige Beschichtung aus CVD- und PCVD-Lagen zeigte eine außergewöhnlich gute mechanische Stabilität der Beschichtung, die den nach dem betreffenden Verfahren hergestellten Werkzeugen eine hohe Standzeit bei Zerspanungsoperationen verschafft. Der besondere Vorteil der abwechselnden Beschichtung mittels des CVD- und des PCVD-Verfahrens liegt darin, daß in einer Beschichtungsanlage in einem durchgehenden Prozeß ohne zwischenzeitliche Abkühlung und Entnahme der zu beschichtenden Gegenstände die Beschichtung aufgetragen werden kann.

Es ist Aufgabe der vorliegenden Erfindung, ein Werkzeug der eingangs genannten Art zu schaffen, dessen Beschichtung feinkörniger ist. Es ist weiterhin Aufgabe der vorliegenden Erfindung, ein Verfahren anzugeben, mit dem diese Beschichtung abgeschieden werden kann und eine Verwendung des Werkzeuges aufzufinden.

Diese Aufgabe wird durch ein Werkzeug nach Anspruch 1 gelöst.

Bei diesem Werkzeug wird die CVD-Beschichtung mehrfach bei im wesentlichen gleichbleibend hoher Temperatur durch eine Plasmabehandlung unterbrochen, allerdings liegt während dieser Plasmabehandlung ein nicht reaktives Gasgemisch aus Argon, Wasserstoff und/oder Stickstoff bei niedrigem Druck von 10 bis 1000 Pa vor, so daß auf die letzte mittels CVD aufgetragene Schicht während der Plasmabehandlung keine Abscheidung erfolgt. Durch die am Substrat angelegte Anregungsspannung von 200 bis 1000 V erodiert die Oberfläche der letzten Beschichtungslage, wobei zahlreiche Fehlstellen in den vorher glatten Kristallitflächen mit wenig wachstumsaktiven Stellen entstehen. Hierdurch wird folgendes erreicht:
Wenn man nach dem nach dem Stand der Technik bekannten (thermischen) CVD-Verfahren z.B. TiC und/oder TiN abscheidet, so entsteht zunächst eine feinkörnige Schicht, die jedoch im Verlauf des weiteren Prozesses durch die Bevorzugung der für das Kristallwachstum günstigen Flächen nach oben stetig grobkörniger wird. Durch die Zunahme der mittleren Korngröße vom Grundkörper zur letzten Beschichtungslage ergibt sich auch eine rauhe Oberfläche der äußersten Beschichtungslage. Die für den Verschleiß und das optische Aussehen ungünstige rauhe Oberfläche konnte bisher nicht vermieden werden, auch nicht durch Temperatur- und/oder Druckerniedrigung bei der Abscheidung oder durch einen mehrlagigen Schichtaufbau mit dünnen Einzelschichten aus unterschiedlichen Hartstoffen. Bei dem erfindungsgemäßen Werkzeug ist daher zunächst eine nach dem herkömmlichen CVD-Verfahren etwa 0,2 bis 0,4 µm dicke Schicht, z.B. TiN, abgeschieden worden, die verhältmäßig feinkörnig ist. Durch Unterbrechung des CVD-Prozeßes und Einstellung eines nicht reaktiven Gemisches bei niedrigem Druck und geringem Gasdurchsatz entstehen bei der anschließenden Plasmabehandlung zahlreiche Fehlstellen in den zuvor glatten Kristallitflächen mit wenig wachstumsaktiven Stellen. Nach Beendigung der Plasmabehandlung und erneuter Einstellung der ursprünglichen CVD-Beschichtungsparameter können auf der fehlstellenreichen Oberfläche zahlreiche Keime gebildet werden, auf denen von neuem ein feinkristallines Wachstum erzeugt wird. Wegen der hohen Oberflächenaktivität ist dieses Wachstum auch beschleunigt gegenüber dem zu erwartenden Wachstum ohne Unterbrechung des CVD-Prozesses durch eine Plasmabehandlung. D.h., der sich infolge der zwischenzeitlichen Plasmabehandlung ergebene Zeitverlust wird durch eine höhere Abscheiderate zumindest teilweise kompensiert. Die alternierende CVD-Beschichtung und die Plasmabehandlung werden so lange wiederholt, bis die gewünschte Schichtdicke erreicht ist. Insgesamt besitzt das so hergestellte Werkzeug eine feinkörnigere Beschichtung als dies nach dem ansonsten üblichen CVD-Prozeß möglich ist.

Weiterbildungen des Werkzeuges sind in den Ansprüchen 2 bis 4 beschrieben.

Vorzugsweise ist die Beschichtung derart aufgetragen worden, daß sich die Temperaturen während der CVD-Verfahren und während der Plasmabehandlung um höchsten 200°C unterscheiden. Weiterhin vorzugsweise wird eine mehrlagige Grundschicht, wie zuvor beschrieben, und eine durch ein ununterbrochenes herkömmliches CVD-Verfahren aufgetragene äußere Deckschicht auf einem Grundkörper angeordnet. Die mehrlagige Grundschicht kann beispielsweise aus Ti(C,N) und die äußere Deckschicht aus Al₂O₃ bestehen.

Die eingangs genannte Aufgabe wird weiterhin durch das im Anspruch 5 beschriebene Verfahren gelöst. Hierbei wird der CVD-Prozeß mehrfach bei im wesentlichen gleichbleibend hoher Temperatur unterbrochen, wobei während der Unterbrechung Gasgemische aus Argon, Helium und/oder Stickstoff bei Drücken von 10 bis 1000 Pa in das Gefäß geleitet werden. An den kathodisch geschalteten Grundkörpern wird eine negative Gleichspannung von 200 V bis 1000 V für eine Zeitspanne von 1 bis 30 Minuten zur Erzeugung einer Glimmentladung aufrechterhalten.

Weiterbildungen dieses Verfahrens sind in den Ansprüchen 6 bis 9 beschrieben.

Da im Unterschied zu dem in der Patentanmeldung WO-A-94/12682 beschriebenen Verfahren die Plasmabehandlung mit einer nicht reaktiven Gasmischung (d.h., z.B. ohne Chloride) durchgeführt wird, sind erhebliche anlagentechnische Vereinfachungen möglich. Das Vakuum während der Plasmabehandlungsphasen kann durch einfache Drehschieberpumpen ohne vorgeschaltete Einrichtungen für die Neutralisation von Metallchloriden und Chlorwasserstoff erzeugt werden. Auch an die Geräte zur Spannungsversorgung für die Erzeugung des Glimmentladungsplasmas können wesentlich geringere Anforderungen gestellt werden als z.B. bei der Durchführung von Plasma-CVD-Beschichtungen, die beispielsweise in der DE 38 41 731 A1 beschrieben werden. Während beim Plasmabeschichtungsverfahren genau definierte Temperaturen, Spannungen und Stromdichten zur Erzielung einer gleichmäßigen Beschichtungen aufrecht erhalten werden müssen, kommt es bei dem vorliegenden erfindungsgemäßen Verfahren nur auf die Einhaltung gewisser Mindestspannungen (200 V) und Mindeststromdichten (5 mA/cm²) an. So kann insbesondere auf aufwendige Generatoren zur Erzeugung von exakt gepulsten Gleichspannungen mit regelbarer Puls- und Pausendauer verzichtet werden; es reichen einfachere Gleichspannungsgeneratoren oder gleichgerichtete Wechselspannungen ohne Glättung zur Erzeugung der notwendigen Spannungen.

Auch das System zur Gasdistribution in der Beschichtungskammer kann vereinfacht werden. Während beim Plasma-CVD-Prozeß mit seinem niedrigen Verfahrensdruck besondere Gaseinlaßsysteme benötigt werden, da die Gasmischung auf dem Weg durch die Beschichtungskammer rasch an TiCl₄ verarmt und es sonst zu einer ungünstigen Verteilung der Schichtdicken in der Kammer kommt, kann bei der erfindungsgemäßen Plasmabehandlung das nichtreaktive Gasgemisch nicht partiell an einer Komponente verarmen, so daß die Gaseinspeisesysteme herkömmlicher CVD-Anlagen unverändert übernommen werden können.

Zur Herstellung der erfindungsgemäßen Werkzeuge bzw. zur Durchführung des vorbeschriebenen Verfahrens wird eine Vorrichtung verwendet, die sich gegenüber einer nach dem Stand der Technik bekannten Apparatur durch mindestens ein elektrisch isoliertes Gestell zur Aufnahme der Grundkörper, eine Spannungsdurchführung in die Kammer für die Grundkörper sowie eine externe Spannungsversorgung unterscheidet. Ggf. kann eine automatische Umschaltung vorgesehen sein, mit deren Hilfe von der CVD-Beschichtung auf die Plasmabehandlung umgeschaltet werden kann.

Die beschriebenen Werkzeuge bzw. die nach dem Verfahren hergestellten Gegenstände werden nach einer weiteren Ausgestaltung der Erfindung als Schneideinsätze zum Drehen, Fräsen, Bohren sowie Gewindeschneiden verwendet.

Im folgenden wird ein Ausführungsbeispiel der Erfindung beschrieben.

In einer nach dem Stand der Technik bekannten CVD-Beschichtungsapparatur, die zur CVD-Beschichtung bei Temperaturen von 1050°C und Vakuumdrücken bis herab zu 6000 Pa eingerichtet war, wurde ein elektrisch isoliertes Chargiergestell und eine vakuumdichte Stromdurchführung eingebaut. Hieran wurde ein Gleichstromversorgungsgerät zur Erzeugung eines Glimmentladungsplasmas angeschlossen. Dieses Gerät verfügte über eine Kurzschluß-Schnellabschaltung und erzeugte temporär überlagerte Spannungsspitzen zur Zündung des Plasmas. Die maximal einstellbare negative Spannung betrug -750 V bei einer Stromstärke von 8 A.

Das verwendete Chargiergestell konnte bis zu 700 Wendeschneidplatten aus Hartmetall mit einer Kantenlänge von 12,4 mm aufnehmen. Die Erzeugung des bei der CVD-Beschichtung eingestellten Vakuumdruckes von beispielsweise 30000 Pa erfolgt durch eine Flüssigkeitsringpumpe, deren Pumpmedium eine schwach basische NaOH-Lösung ist, die neben der Vakuumerzeugung gleichzeitig zur Neutralisation der Abgase des Beschichtungsprozesses, der z.B. unverbrauchte Metallchloride und Chlorwasserstoff enthält, dient. Die Vorrichtung ist ferner mit einer Drehschieber-Vakuumpumpe ausgerüstet, die in einer CVD-Anlage ursprünglich nur zum Prüfen der Vakuumdichtigkeit der Beschichtungkammer vorgesehen war, nun aber auch für die Plasmabehandlung genutzt werden kann. Zur CVD-Apparatur gehören nach dem Stand der Technik bekannte Systeme zur Herstellung der beim Beschichtungsprozeß benötigten Gasmischungen aus den Chloriden von Titan, Zirkon und/oder Aluminium und aus Wasserstoff, Stickstoff, Methan, Kohlendioxid und/oder Argon. Mit diesen Systemen lassen sich auch Gasmischungen für die genannte Plasmabehandlung bereitstellen.

Zur Herstellung eines erfindungsgemäßen Werkzeuges wurden das Chargiergestell mit 250 Wendeschneidplatten der Ausführung CNMG120412 (Bezeichnung nach DIN 4987) aus Hartmetall (bestehend aus 6% Co, 2 TiC, 4% TaC, Rest WC) beladen. Die Beschichtungskammer wurde evakuiert und mit Wasserstoff gefüllt. Nach dem Aufheizen durch einen über die Kammer gestülpten Ofen auf eine Temperatur von 980°C wurde ein Druck von 30000 Pa eingestellt. Unter diesen Bedingungen wurde im nächsten Schritt ein Gasgemisch aus 1,5% TiCl₄, 3,2% CH₄, 12% N₂ und 83,3% H₂ 20 Minuten lang über die Proben zur Abscheidung einer Ti(C,N)-Schicht geleitet. Danach wurde die Zufuhr von TiCl₄ und CH₄ eingestellt und ein neues Gasgemisch aus 10% N₂, 10% H₂ und 80% Ar in den Reaktor eingeleitet. Bei gleichbleibender Temperatur wurde auf das Pumpsystem mit der Drehschieber-Vakuumpumpe umgeschaltet und der Druck auf 200 Pa herabgesetzt. Danach wurde eine Gleichspannung von -600 V an das Chargiergestell gelegt. Durch die Messung des Entladungsstromes konnte indirekt auf die Entstehung der Glimmentladung und den Beginn der Plasmabehandlung geschlossen werden. Nach Ablauf von 5 Minuten wurden Spannung und Drehschieberpumpe abgeschaltet, der Druck auf 30000 Pa erhöht, auf das Hauptpumpsystem geschaltet und erneut das oben angegeben reaktive Gasgemisch durch die Kammer geleitet. Diese genannten beiden Verfahrensschritte wurden mehrfach wiederholt, so daß insgesamt 10 CVD-Beschichtungsschritte und 9 Plasmabehandlungsschritte durchgeführt wurden. Die Abkühlung der Charge erfolgte anfangs in Wasserstoff, später in Stickstoff.

Zum Vergleich der erfindungsgemäßen Werkzeuge mit solchen Werkzeugen, die nach dem herkömmlichen CVD-Verfahren beschichtet worden sind, sind unter Einstellung der obengenannten Parameter der CVD-Phase Grundkörper (unter Auslassung der Plasmabehandlung) beschichtet worden. Die Zeitdauer der CVD-Beschichtung betrug 150 Minuten.

Von beiden Versuchen wurden nach dem Abkühlen und öffnen Proben aus dem oberen, mittleren und unteren Teil des Chargiergestelles entnommen und die hergestellten Schichten metallographisch mit Hilfe der Kalottenschliffmethode untersucht. Unter dem Mikroskop konnte beobachtet werden, daß beide Beschichtungen keine Absplitterungen am Übergang zwischen dem Substrathartmetall und der Beschichtung zeigten und eine gleichmäßig lila-braune Farbe aufwiesen. Die Probe mit den zwischenzeitlichen Plasmabehandlungsschritten schien eine Spur dunkler zu sein, was aber auch auf durch das Diamantschleifmittel verursachte Unterschiede zurückzuführen sein könnte. Eine Struktur ähnlich wie bei einer Mehrlagenbeschichtung war nur an den oberen Proben mit Mühe zu erkennen. Die Ausmessung der Schichtdicken ergab folgende Resultate:

| Lage im Chargiergestell | Schichtdicken in µm | |
|---|---|---|
| | Versuch mit Plasmabehandlung | Versuch ohne Plasmabehandlung |
| oben | 15,6 | 10,6 |
| Mitte | 13,9 | 9,3 |
| unten | 10,4 | 7,0 |
| Beschichtungszeit | 150 min | 150 min |
| Behandlungszeit | 45 min | --- |

Es fällt auf, das die Schichtdicken der Proben mit den Plasmabehandlungsschritten eine um etwa 30% größere Schichtdicke als die des Vergleichsversuches aufweisen. Die Ergebnis deutet auf eine erhöhte Schichtwachstumsgeschwindigkeit jeweils nach der Durchführung eines Behandlungschrittes hin.

Einige Proben wurden gebrochen und Bruchstücke mit anhaftender Schicht mit Hilfe eines Rasterelektronenmikroskopes bei 6000-facher Vergrößerung untersucht. Wenn auch eine genaue Bestimmung der Größen der Kristallite der Schichten nicht möglich war, so war bei den erfindungsgemäßen Proben doch ein deutlich feineres Schichtgefüge zu erkennen, das gleichmäßig vom unteren bis zum oberen Teil der gesamten Schicht ausgebildet war. Die Proben des Vergleichsversuches wiesen dagegen im äußeren Teil der Schicht deutlich gröbere Kristallite auf. Dies zeigte sich auch bei der Betrachtung der äußeren Schichtoberfläche an ungebrochenen Proben. Die Proben des Vergleichsversuches wiesen eine schotterartige, rauhe Oberfläche mit scharfen Dachkantprismen auf, während die erfindungsgemäßen Proben eine glatte, leicht wellige Oberflächenstruktur zeigten. Schließlich wurden noch bei Röntgenbeugungsuntersuchungen Linienverbreiterungen beobachtet, die ebenfalls die erheblich feinere Gefügestruktur der erfindungsgemäßen Proben beweisen.

Zur Prüfung der Gebrauchseigenschaften wurden aus den Chargen der beiden Versuche Platten herausgesucht, deren Schichtdicken im Bereich zwischen 10 und 11 µm lagen, um den Einfluß unterschiedlicher Schichtdicken auszuschließen. Diese Wendeschneidplatten wurden in industrieller Fertigungspraxis beim Drehen von Achszapfen mit einem maximalen Durchmesser von 246 mm und einer Länge von 310 mm aus dem Werkstoff 42CrMo4V getestet. Die Schnittgeschwindigkeit variierte wegen der Verjüngungen der Durchmesser von 75 m/min bis 180 m/min. Die Schnittiefen lagen bei 4 bis 6 mm und der Vorschub betrug 0,18 mm/Umdrehung. Mit der erfindungsgemäßen Beschichtung konnten pro Schneidecke 12 bis 15 Werkstücke bearbeitet werden, während mit den zum Vergleich in herkömmlicher Weise beschichteten Wendeschneidplatten trotz gleicher Schichtdicken nur 6 bis 8 Werkstücke gefertigt wurden. Da weder beim Substrat noch bei der Schicht Unterschiede in der stofflichen Zusammensetzung vorliegen, muß diese Verbesserung der Gebrauchseigenschaft allein der durch die erfindungsgemäße besondere Beschichtungsmethode erzielten feinkörnigen Gefügestruktur zugeschrieben werden.

Das erzielte dichte, feinkörnige, über die gesamte Schichtdicke gleichmäßige Gefüge führt sowohl zu einer glatten Oberfläche als auch wegen der hohen Zahl der Korngrenzflächen zu einer guten Anpassung den durch die Wärmedehnung des Substrates ausgelösten Spannungen. Daher sind die aufgetragenen Schichten weniger der Gefahr der Bildung von Mikrorissen ausgesetzt, die bruchauslösend sein können.

## Patentansprüche

1. Werkzeug aus einem Grundkörper aus Hartmetall oder Cermet und einer auf dem Grundkörper aufgebrachten aus Carbiden, Nitriden und/oder Carbonitriden des Titans und/oder Zirkoniums und/oder Aluminiumoxid bestehenden mehrlagigen mittels eines CVD-Verfahrens aufgetragenen Oberflächenbeschichtung,
**dadurch gekennzeichnet,**
daß mindestens eine Lage derart hergestellt worden ist, daß die CVD-Abscheidung mehrfach durch eine Plasmabehandlung über eine Zeitdauer von 1 bis 30 Minuten dadurch unterbrochen wird, daß die Zufuhr der Reaktionsgase eingestellt und nicht reaktive Gasgemische aus Argon, Wasserstoff und/oder Stickstoff bei Drücken von 10 bis 1000 Pa in das Beschichtungsgefäß eingeleitet werden und daß zur Aufrechterhaltung einer Glimmentladung an den Grundkörper oder den teilbeschichteten Grundkörper während dieser Zeitdauer eine negative Gleichspannung von 200 V bis 1000 V angelegt wird.

2. Werkzeug nach Anspruch 1, dadurch gekennzeichnet, daß sich die Temperaturen während der CVD-Beschichtung und während der Zeitdauer der Unterbrechung um höchstens 200°C unterscheiden.

3. Werkzeug nach Anspruch 1 oder 2, gekennzeichnet durch eine mehrlagige Grundschicht und eine durch ein ununterbrochenes CVD-Verfahren aufgetragene äußere Deckschicht.

4. Werkzeug nach Anspruch 3, dadurch gekennzeichnet, daß die mehrlagige Grundschicht aus Ti(C,N) und die äußere Deckschicht aus Al₂O₃ besteht.

5. Verfahren zur Beschichtung eines Grundkörpers aus Hartmetall oder Cermet mit mehreren aus Carbiden, Nitriden und /oder Carbonitriden des Titans und/oder Zirkoniums und/oder Aluminiumoxid bestehenden Lagen mittels eines CVD-Abscheideverfahrens, wozu die zur Zusammensetzung der einzelnen Lagen notwendigen Reaktionsgase in ein Beschichtungsgefäß eingeleitet werden, dadurch gekennzeichnet, daß die CVD-Abscheidung mehrfach über eine Zeitdauer von 1 bis 30 Minuten dadurch unterbrochen wird, daß die Zufuhr der Reaktionsgase eingestellt und nicht reaktive Gasgemische aus Argon, Wasserstoff und/oder Stickstoff bei Drücken von 10 bis 1000 Pa in das Beschichtungsgefäß eingeleitet werden und daß zur Aufrechterhaltung einer Glimmentladung an den kathodisch geschalteten Grundkörper oder den teilbeschichteten Grundkörper während dieser Zeitdauer eine negative Gleichspannung von 200 V bis 1000 V angelegt wird.

6. Verfahren nach Anspruch 5, dadurch gekennzeichnet, daß sich die Temperaturen während der CVD-Beschichtung und während der Zeitdauer der Unterbrechung um höchstens 200°C unterscheiden und/oder daß die Drücke während der Zeitdauer der Unterbrechung zwischen 100 und 500 Pa, vorzugsweise bei 200 Pa, liegen.

7. Verfahren nach Anspruch 5 oder 6, dadurch gekennzeichnet, daß die negative Gleichspannung während der Zeitdauer der Unterbrechnung zwischen 400 V und 800 V liegt und/oder daß die negative Gleichspannung während der Zeitdauer der Unterbrechung konstant, gepulst oder eine gleichgerichtete Wechselspannung ist, der eine höher frequente Wechselspannung überlagert ist.

8. Verfahren nach einem der Ansprüche 5 bis 7, dadurch gekennzeichnet, daß die einzelnen CVD-Abscheidungsphasen jeweils zwischen 5 bis 60 Minuten, vorzugsweise 10 bis 30 Minuten, liegen und/oder daß das zeitliche Verhältnis einer einzigen CVD-Phase zu einer einzigen Plasmabehandlungsphase zwischen 2:1 und 10:1 ist.

9. Verfahren nach einem der Ansprüche 5 bis 8, dadurch gekenn zeichnet, daß nach der Abscheidung der äußeren Schicht unter Wasserstoff und/oder Stickstoff abgekühlt wird, vorzugsweise zunächst unter Wasserstoff und anschließend unter Stickstoff.

10. Verwendung der Werkzeuge nach einem der Ansprüche 1 bis 4 zum Drehen, Fräsen, Bohren oder Gewindeschneiden.

## Claims

1. Tool of a base body of hard metal or cermet and of a multilayer surface coating of carbides, nitrides and/or carbonitrides of titanium and/or zirconium and/or aluminium oxide applied to the base body by means of a CVD process, characterized in that at least one layer is produce in such a manner that the CVD process is interrupted several times during a period of 1 to 30 minutes while the supply of reaction gas is interrupted and a non reactive gas mixture of argon, hydrogen and/or nitrogen is admitted to the coating vessel at a pressure of 10 to 1000 Pa and that during this period for the maintainance of a glow discharge a negative DC voltage of 200 V to 1000 V is applied to the base or the partly coated base body.

2. A tool according to claim 1 characterized in that the temperatures during the CVD coating and the period of interruption differ by at most 200 °C.

3. A tool according to claim 1 or 2 characterized by a multilayer base layer and an outer layer applied by an uninterrupted CVD process.

4. The tool according to claim 3 characterized that in the multilayer base layer is comprised of Ti (C,N) and the outer layer is comprised of Al₂O₃.

5. Process for coating a base body of hard metal or cermet with a plurality of layers comprised of carbides, nitrides and/or carbonitrides of titanium and/or zirconium and/or aluminium oxide by means of a CVD deposition process for which in the coating vessel are feeded reaction gases necessary for the composition of the individual layers, characterized in that the CVD deposition is interrupted several times during a period of 1 to 30 minutes by interrupting the supply of the reaction gas and admitting a non reactive gas mixture of argon, hydrogen and/or nitrogen into the coating vessel at pressures of 10 to 1000 Pa and in that during this period for the maintainance of a glow discharge a negative DC voltage of 200 V to 1000 V is applied to the cathodically connected base body or the partly coated base body.

6. Process according tto claim 5 characterized in that the temperatures of the CVD coating and the period of interruption differ by a maximum of 200 °C and (or that the pressures lie between 100 and 500 Pa, preferably at 200 Pa.

7. Process according to claim 5 or 6 characterizd in that the negative voltage lies between 400 and 800 V during the time period of interruption and/or that the negative voltage is constant, pulsed or is a rectified alternating current on which a higher frequency alternating voltage is superimposed.

8. Process according to one of the claims 5 to 7 characterized in that the duration of the individual CVD phases lies between 5 to 60 minutes, preferably between 10 to 30 minutes and/or that the time ratio of the duration of a single CVD phase to a single plasma treatment phase is 2:1 to 10:1.

9. Process according to one of the claims 5 to 8 characterized in that after the deposition of the outer layer, the coated body is cooled under hydrogen and/or nitrogen, preferably initially under hydrogen and subsequently under nitrogen.

10. Use of the tool according to one of the claims 1 to 4 for turning, milling, boring or thread cutting.

## Revendications

1. Outil se composant d'un corps de base en métal dur ou cermet et d'un revêtement de surface à plusieurs couches qui est appliqué au corps de base par le biais d'un procédé CVD et qui se compose de carbures, de nitrures et/ou de carbonitrures du titane et/ou du zirconium et/ou d'oxyde d'aluminium,
**caractérisé par le fait**
que du moins une couche était fabriquée de telle manière que la déposition CVD est interrompue à plusieurs reprises par un traitement à plasma pendant une durée de 1 à 30 minutes par le fait que l'amenée des gaz de réaction est arrêtée et que des mélanges gazeux non réactifs se composant d'argon, d'hydrogène et/ou d'azote sont introduits dans le vase de revêtement à des pressions comprises entre 10 et 1000 Pa, et que, pour maintenir une décharge lumineuse, une tension continue négative de 200 V à 1000V est appliquée pendant cette durée au corps de base ou au corps de base revêtu en partie.

2. Outil selon la revendication 1, caractérisé par le fait que les températures durant le revêtement CVD et pendant la durée de l'interruption diffèrent l'une de l'autre de 200°C au maximum.

3. Outil selon la revendication 1 ou 2, caractérisé par une couche de base à plusieurs couches et par une couche extérieure appliquée par un procédé CVD ininterrompu.

4. Outil selon la revendication 3, caractérisé par le fait que ladite couche de base à plusieurs couches se compose de Ti(C,N) et la couche extérieure se compose de Al₂O₃.

5. Procédé de revêtement d'un corps de base en métal dur ou cermet avec plusieurs couches se composant de carbures, de nitrures et/ou de carbonitrures du titane et/ou du zirconium et/ou d'oxyde d'aluminium, par le biais d'un procédé CVD de déposition, les gaz de réaction nécessaires à la composition des couches individuelles étant introduits dans un vase de revêtement, caractérisé par le fait que la déposition CVD est interrompue à plusieurs reprises pendant une durée de 1 à 30 minutes par le fait que l'amenée des gaz de réaction est arrêtée et que des mélanges gazeux non réactifs se composant d'argon, d'hydrogène et/ou d'azote sont introduits dans le vase de revêtement à des pressions comprises entre 10 et 1000 Pa, et que, pour maintenir une décharge lumineuse, une tension continue négative de 200 V à 1000 V est appliquée pendant cette durée au corps de base connecté de façon cathodique ou au corps de base revêtu en partie.

6. Procédé selon la revendication 5, caractérisé par le fait que les températures durant le revêtement CVD et pendant la durée de l'interruption diffèrent l'une de l'autre de 200°C au maximum et/ou que les pressions pendant la durée de l'interruption sont comprises entre 100 et 500 Pa, de préférence se situent à 200 Pa.

7. Procédé selon la revendication 5 ou 6, caractérisé par le fait que la tension continue négative pendant la durée de l'interruption est comprise entre 400 V et 800 V et/ou que la tension continue négative pendant la durée de l'interruption est constante, pulsée ou est une tension alternative redressée qui est superposée d'une tension alternative de plus haute fréquence.

8. Procédé selon l'une des revendications 5 à 7, caractérisé par le fait que les phases individuelles de déposition CVD sont comprises respectivement entre 5 et 60 minutes, de préférence entre 10 et 30 minutes et/ou que le rapport temporel d'une seule phase CVD à une seule phase de traitement à plasma est compris entre 2 à 1 et 10 à 1.

9. Procédé selon l'une des revendications 5 à 8, caractérisé par le fait que l'on effectue un refroidissement sous hydrogène et/ou azote après la déposition de la couche extérieure, de préférence d'abord sous hydrogène et ensuite sous azote.

10. Utilisation des outils selon l'une des revendications 1 à 4 pour le tournage, le fraisage, le perçage, le taraudage ou le filetage.
